# FASCICULE DE BREVET EUROPEEN

(11) **EP 0 797 689 B1**
(45) Date de publication et mention de la délivrance du brevet: **16.09.1998**
(21) Numéro de dépôt: 95941752.8
(22) Date de dépôt: 01.12.1995
(51) Int. Cl.: C23C 16/44, B01D 53/46

(54) **DISPOSITIF D'EXTRACTION DE GAZ**
GASEXTRAKTIONSVORRICHTUNG
GAS REMOVAL DEVICE

(30) Priorité: 05.12.1994 FR 9414584
(43) Date de publication de la demande: 01.10.1997
(73) Titulaire: SOCIETE NATIONALE D'ETUDE ET DE CONSTRUCTION DE MOTEURS D'AVIATION, "S.N.E.C.M.A.", 75015 Paris (FR)
(72) Inventeur: CHARVET, Jean-Luc, F-33160 Saint-Medard-en-Jalles (FR); GOUJARD, Stéphane, F-33700 Merignac (FR)
(74) Mandataire: Joly, Jean-Jacques
(86) Numéro de dépôt international: FR9501587
(87) Numéro de publication internationale: WO9617972

(56) Documents cités:
- WO-A-87/04733
- PATENT ABSTRACTS OF JAPAN vol. 008 no. 145 (C-232) ,6 Juillet 1984 & JP,A,59 050165 (SONY KK) 23 Mars 1984,
- SERI PHOTOVOLTAICS SAFETY CONFERENCE, LAKEWOOD, CO, USA, 16-17 JAN. 1986, vol. 19, no. 3-4, ISSN 0379-6787, SOLAR CELLS, JAN. 1987, SWITZERLAND, pages 189-201, DICKSON C R 'Safety procedures used during the manufacturing of amorphous silicon solar cells'
- PATENT ABSTRACTS OF JAPAN vol. 009 no. 056 (E-302) ,12 Mars 1985 & JP,A,59 197141 (SONY KK) 8 Novembre 1984,
- PATENT ABSTRACTS OF JAPAN vol. 011 no. 172 (C-354) [2228] ,18 Juin 1986 & JP,A,61 023758 (TOSHIBA KK) 1 Février 1986,
- PATENT ABSTRACTS OF JAPAN vol. 006 no. 177 (C-124) ,11 Septembre 1982 & JP,A,57 094323 (STANLEY ELECTRIC CO LTD) 11 Juin 1982,

## Description

La présente invention concerne les installations industrielles de fabrication de pièces en matériau composite comprenant des fours d'infiltration ou dépôt chimique en phase vapeur. Plus particulièrement, l'invention a pour objet un dispositif d'extraction de gaz pour de telles installations.

Une technique connue de fabrication de pièces en matériaux composites, en particulier de pièces en matériaux composites thermostructuraux, tels que les composites carbone-carbone ou les composites à matrice céramique, consiste à réaliser des préformes des pièces et à densifier les préformes dans des fours d'infiltration ou dépôt chimique en phase vapeur. Les préformes des pièces sont généralement constituées par des textures fibreuses. Les préformes, éventuellement maintenues en forme par des outillages, sont introduites dans un four où est admise une phase gazeuse dont la composition est choisie en fonction de la nature de la matrice du matériau composite. Dans des conditions prédéterminées de température et de pression, la phase gazeuse diffuse au sein de la porosité des préformes et, par décomposition d'un de ses constituants ou réaction entre plusieurs constituants, laisse un dépôt solide qui densifie progressivement les préformes en comblant leur porosité, afin de former la matrice.

L'infiltration ou le dépôt chimique en phase vapeur s'effectuant sous basses pressions, il est nécessaire de prévoir des moyens de pompage reliés au four. Une installation industrielle d'infiltration chimique en phase vapeur fonctionnant avec une pompe à anneau d'eau est décrite dans le document WO 87/04733.

Des produits de réaction gazeux et/ou des résidus de la phase gazeuse qui sont extraits du four par pompage peuvent poser des problèmes en raison de leur nature toxique ou corrosive, ou de leur tendance à former des dépôts parasites.

Il en est ainsi en particulier dans le cas de la fabrication de pièces en matériaux composites dont les matrices sont au moins partiellement constituées par une phase céramique telle qu'un carbure de silicium (SiC par exemple), ou encore plus particulièrement lorsque la matrice comprend au moins une phase constituée par une céramique telle que le carbure de bore (B₄C) ou un système ternaire silicium-bore-carbone (Si-B-C), comme décrit dans le document FR-A-2 668 477.

En effet, les précurseurs utilisés dans la phase gazeuse comprennent alors habituellement des halogénures gazeux, notamment des chlorures gazeux, qui, outre leur caractère corrosif et leur toxicité, peuvent former d'importants dépôts solides en sortie du four. Il en est ainsi, en particulier avec le trichlorure de bore BCl₃, précurseur de l'élément bore.

Dans l'installation évoquée plus haut utilisant une pompe à anneau d'eau, il a ainsi été observé par la demanderesse que la présence d'humidité en entrée de la pompe provoque, par réaction avec des chlorures gazeux, des dépôts solides qui amènent un colmatage progressif et inéluctable des canalisations de pompage. Il est alors nécessaire de procéder fréquemment à l'entretien, voire au remplacement, des composants du dispositif de pompage, opérations qui nécessitent de grandes précautions en raison du caractère souvent instable des dépôts solides parasites.

On connaît aussi du document "PATENT ABSTRACTS OF JAPAN Vol. 008 No 145 (C-232), 6 juillet 1984" une installation de réaction sous vide comprenant un dispositif de piégeage pour liquéfier des gaz n'ayant pas réagi par refroidissement et une association pompe sèche et pompe à anneau d'eau afin d'évacuer les espèces gazeuses restantes. On retrouve donc les inconvénients liés à l'utilisation d'une pompe humide.

Aussi, la présente invention a-t-elle pour but de fournir un dispositif d'extraction de gaz qui évite les inconvénients précités, en particulier qui évite la formation de dépôts parasites pouvant engendrer des colmatages. La présente invention a aussi pour but de fournir un dispositif d'extraction comprenant des moyens de traitement de gaz corrosifs et toxiques issus du four, avant rejet à l'atmosphère.

Ce but est atteint grâce à un dispositif d'extraction de gaz comprenant une pompe sèche ayant une entrée reliée au four pour permettre l'établissement, à l'intérieur du four, de conditions de basses pressions désirées, et l'extraction de gaz résiduels ; et un réacteur d'hydrolyse à pression atmosphérique relié à une sortie de la pompe sèche et destiné à recevoir des gaz résiduels provenant du four, le réacteur d'hydrolyse comprenant une première sortie pour des dépôts solides ou solutions acides provenant de l'hydrolyse des gaz reçus et une deuxième sortie de gaz reliée à l'atmosphère.

Avantageusement, des moyens sont prévus pour injecter un gaz, de préférence un gaz neutre, tel que l'azote, entre l'entrée de la pompe sèche et l'entrée du réacteur d'hydrolyse. L'injection de gaz peut être effectuée à la fois en entrée de la pompe sèche et dans une canalisation reliant la pompe sèche au réacteur d'hydrolyse. Outre un effet de dilution des gaz extraits du four, cette injection de gaz contribue à s'opposer à un contre-courant entre le réacteur d'hydrolyse et la pompe et à éviter ainsi la remontée vers la pompe de produits de la réaction d'hydrolyse.

Des moyens d'alimentation en eau sont avantageusement prévus pour établir une circulation liquide en continu entre au moins un accès au réacteur d'hydrolyse et la première sortie de celui-ci.

De préférence, les moyens d'alimentation en eau sont reliés au réacteur d'hydrolyse au moins à travers la deuxième sortie de celui-ci, afin de pouvoir mettre en solution des vapeurs acides issues du réacteur et éviter leur rejet dans l'atmosphère. A cet effet, les moyens d'alimentation en eau peuvent être raccordés à une entrée d'injection d'eau dans une colonne reliée à la deuxième sortie du réacteur.

Egalement pour éviter des rejets toxiques ou corrosifs, la première sortie du réacteur d'hydrolyse est reliée à un bac de neutralisation afin de neutraliser des solutions acides produites par hydrolyse.

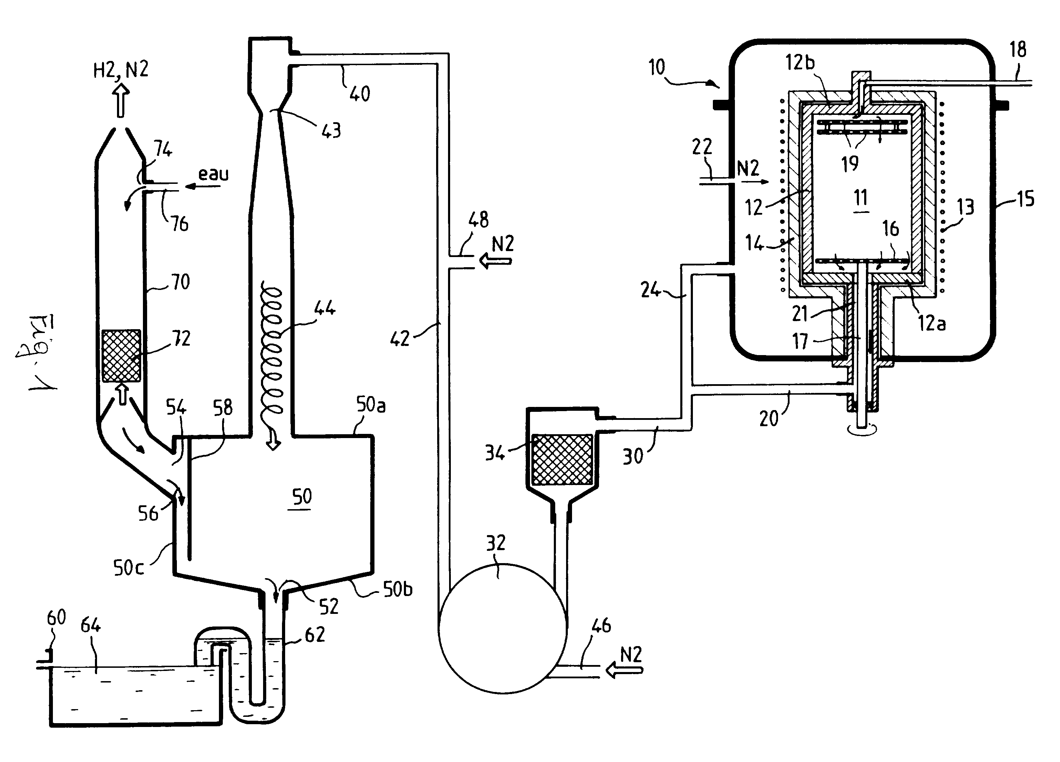

Un mode particulier de réalisation de l'invention est décrit ci-après, à titre indicatif mais non limitatif, en référence au dessin annexé dont la figure unique est une vue d'ensemble très schématique d'un dispositif d'extraction de gaz conforme à l'invention.

Le dispositif d'extraction de gaz illustré est relié à la sortie d'un four 10 d'infiltration chimique en phase vapeur par exemple tel que décrit dans le document WO 87/04733 déjà cité. Très sommairement, le four 10 comprend une chambre de réaction 11 délimitée par un induit en graphite 12. L'induit est entouré par un inducteur métallique 13 avec interposition d'un isolant thermique 14. L'ensemble est logé à l'intérieur d'une enceinte métallique étanche 15.

L'induit 12 a la forme d'un cylindre d'axe vertical fermé à sa partie inférieure par un fond 12a et à sa partie supérieure par un couvercle amovible 12b. A l'intérieur de la chambre 11, les préformes à densifier sont placées sur un plateau perforé 16. Les préformes (non représentées) sont par exemple des structures fibreuses ayant une forme proche de celle de pièces à réaliser en matériau composite, éventuellement maintenues dans un outillage. Le plateau 16 peut tourner autour d'un axe vertical confondu avec celui de la chambre 11. La rotation est commandée par un moteur (non représenté) couplé au plateau par un arbre 17 traversant le fond 12a.

Une phase gazeuse réactionnelle contenant le ou les précurseurs de la matrice du matériau composite provenant de réserves (non représentées) est introduite dans la chambre 11 par une canalisation d'amenée 18 qui traverse l'enceinte 15 et aboutit à la partie supérieure de la chambre à travers le couvercle 12b. Un débit complémentaire de gaz neutre, par exemple de l'azote, peut être ajouté à la phase gazeuse réactionnelle pour régler la pression dans la chambre. La phase gazeuse réactionnelle pénétrant dans la chambre 12 est forcée à circuler au contact de plateaux de préchauffage. Ceux-ci, formés de plaques perforées superposées 19, permettent de porter rapidement la phase gazeuse réactionnelle à la température régnant dans la chambre.

L'extraction de la phase gazeuse résiduelle est réalisée à travers une ou plusieurs canalisations 20 qui sont reliées à la partie inférieure de la chambre 11 par un passage annulaire 21 entourant l'arbre 17.

Le volume situé autour de l'induit 12 à l'intérieur de l'enceinte 11 est balayé en permanence par un gaz neutre, tel que de l'azote. Celui-ci est amené par une canalisation 22. Il est extrait de l'enceinte 15 par une canalisation 24. Un tampon de gaz neutre est ainsi formé autour de la chambre 11.

A l'extérieur de l'enceinte, les canalisations 20 et 24 se rejoignent pour former une canalisation unique 30.

De façon connue, une unité de contrôle (non représentée) reçoit des signaux produits par des capteurs et représentatifs de la température et de la pression dans la chambre 11 et commande un générateur 28 qui fournit le courant d'alimentation de l'inducteur de manière à maintenir la température dans la chambre à la valeur optimale prédéterminée pour l'opération d'infiltration chimique en phase vapeur.

Comme indiqué plus haut, la densification des préformes contenues dans le four d'infiltration par une matrice céramique, en particulier une matrice formée au moins partiellement à partir du système ternaire Si-B-C, y compris SiC, B₄C et SiB₄, fait appel à des précurseurs dans la phase gazeuse constitués par des gaz toxiques, corrosifs et susceptibles de former des dépôts parasites en sortie du four 10. Ces gaz précurseurs sont en particulier des chlorures gazeux tels que SiₓH_{y}Cl_{z} ou BₜHᵤClᵥ (x, y, z, t, u et v étant des nombres entiers).

Selon une particularité du dispositif conforme à l'invention, l'extraction des gaz hors du four est réalisée au moyen d'une pompe sèche 32 reliée au four 10 par la canalisation 30 et commandée par l'unité de contrôle de l'installation. Par pompe sèche, on entend ici une pompe qui, pour son fonctionnement, ne fait appel à aucun liquide, tel que l'huile ou l'eau, susceptible de réagir avec les gaz issus du four pour former des dépôts parasites. On pourra par exemple utiliser la pompe commercialisée par la société Edwards sous l'appellation Pompe Sèche DP 180. Cette pompe offre en outre l'avantage d'avoir une température de fonctionnement réglable jusqu'à 160°C, ce qui permet de choisir une température de fonctionnement évitant tout phénomène de recondensation dans le corps de la pompe. Un filtre 34 peut être monté dans la canalisation 30 pour retenir les particules solides ayant une dimension supérieure à une limite comprise de préférence entre 10 et 15 microns. Le filtre 34 est par exemple constitué par un grillage fin en acier inox, enroulé sur lui-même, tel que le filtre à effets cycloniques I.T.F. commercialisé par la société Edwards.

Des moyens de traitement des gaz extraits par la pompe sont prévus en aval de celle-ci afin d'éviter le rejet de gaz toxiques et corrosifs à l'atmosphère et la formation de dépôts parasites en sortie de pompe.

Les moyens de traitement comprennent un réacteur d'hydrolyse 50 fonctionnant à pression atmosphérique et relié à la sortie de la pompe 32 par une canalisation 40. Les gaz issus de la pompe parviennent au réacteur suivant un trajet ascendant, à travers une première partie 42 de la canalisation 40, puis, suivant un trajet descendant, tout d'abord à travers un venturi 43 à jet de gaz, puis à travers un tube 44 dans lequel est insérée une partie hélicoïdale et qui forme la partie verticale terminale de la canalisation 40. Le tube 44 aboutit à la partie supérieure du bac d'hydrolyse 50, à travers un couvercle 50a.

Les solutions acides et dépôts solides produits par l'hydrolyse des gaz résiduels extraits par la pompe sont évacués à travers une sortie 52, s'ouvrant dans le fond 50b du réacteur d'hydrolyse. La sortie 52 est reliée à un bac de neutralisation 60 au moyen d'une conduite 62. Le bac 60 contient un bain 64 propre à neutraliser les solutions acides qui y sont amenées par la conduite 62.

Un gaz neutre, par exemple de l'azote, est injecté dans le circuit des gaz extraits du four, d'une part, en entrée de la pompe 32, par une conduite 46 et, d'autre part, dans la partie 42 de la liaison entre la pompe et le réacteur d'hydrolyse, en amont du venturi 43, par une conduite 48.

L'injection d'azote a pour effet de diluer les gaz à l'entrée de la pompe 32 et de s'opposer à une remontée vers la pompe de vapeurs acides ou particules solides depuis le réacteur d'hydrolyse 50, évitant ainsi un colmatage de l'évent de pompe. Le venturi 43 et le tube 44 de la partie de canalisation 42 aboutissant au réacteur d'hydrolyse et le sens descendant des gaz dans le tube 44 renforcent la fonction d'interface entre la pompe 32 et le réacteur d'hydrolyse 50 qui est assurée par l'injection d'azote.

Le réacteur d'hydrolyse 50 a une sortie de gaz 54 communiquant avec l'atmosphère à travers une colonne à plateau 70. Un filtre 72, par exemple constitué par des anneaux de "Rashig" est inséré dans la colonne 70. Une entrée d'injection d'eau 74 est prévue dans la colonne 70, à la partie supérieure de celle-ci, et communique avec une réserve d'eau (non représentée) par une conduite 76. L'eau ainsi injectée forme un brouillard dans la colonne et pénètre dans le réacteur d'hydrolyse 50 à travers la sortie 54 en formant un rideau d'eau 56. Celui-ci s'écoule dans une zone du réacteur d'hydrolyse délimitée par la paroi latérale 50c où est formée la sortie 54 et une cloison 58 parallèle à la paroi 50c et s'étendant sur la plus grande partie de la hauteur du réacteur d'hydrolyse 50, depuis le couvercle 50a. De la sorte des vapeurs acides éventuellement entraînées hors du réacteur 50 à travers la sortie 54 sont dissoutes et renvoyées dans le réacteur pour être évacuées par la sortie 52.

Dans l'exemple envisagé plus haut où le four d'infiltration 10 est alimenté en une phase gazeuse contenant des gaz précurseurs de SiC ou d'un système ternaire Si-B-C ou de B₄C, les chlorures gazeux SiₓH_{y}Cl_{z} ou BₜHᵤClᵥ sont transformés dans le réacteur d'hydrolyse en une solution d'acide chlorhydrique et en oxydes solides SiO₂ et B₂O₃ avec libération d'hydrogène. Les espèces gazeuses rejetées dans l'atmosphère au sommet de la colonne 70 sont alors constituées pratiquement par du gaz hydrogène et l'azote injecté dans le dispositif d'extraction.

## Revendications

1. Dispositif d'extraction de gaz pour un four d'infiltration ou dépôt chimique en phase vapeur dans une installation industrielle de fabrication de pièces en matériau composite, caractérisé en ce qu'il comporte :
- une pompe sèche (32) ayant une entrée reliée au four (10) pour permettre l'établissement, à l'intérieur du four, de conditions de basses pressions désirées, et l'extraction de gaz résiduels ; et
- un réacteur d'hydrolyse (50) à pression atmosphérique relié à une sortie de la pompe sèche et destiné à recevoir des gaz résiduels provenant du four, le réacteur d'hydrolyse comprenant une première sortie (52) pour des dépôts solides ou solutions acides provenant de l'hydrolyse des gaz reçus et une deuxième sortie de gaz (54) reliée à l'atmosphère.

2. Dispositif selon la revendication 1, caractérisé en ce qu'il comprend des moyens d'injection de gaz (46, 48) entre l'entrée de la pompe sèche (32) et le réacteur d'hydrolyse (50) afin d'éviter un contre-courant du réacteur d'hydrolyse vers la pompe.

3. Dispositif selon la revendication 2, caractérisé en ce que les moyens d'injection de gaz (46, 48) sont reliés, d'une part, à la pompe sèche (32), en entrée de celle-ci et, d'autre part, à une canalisation (42) reliant la pompe sèche au réacteur d'hydrolyse (50).

4. Dispositif selon l'une quelconque des revendications 1 à 3, caractérisé en ce qu'il comprend des moyens d'alimentation en eau (74, 76) permettant une circulation liquide continue entre au moins un accès au réacteur d'hydrolyse (50) et la première sortie (52) de celui-ci.

5. Dispositif selon la revendication 4, caractérisé en ce que les moyens d'alimentation en eau (74, 76) sont reliés au réacteur d'hydrolyse (50) au moins à travers la deuxième sortie (54) de celui-ci afin de mettre en solution des vapeurs acides issues du réacteur d'hydrolyse et éviter leur rejet dans l'atmosphère.

6. Dispositif selon la revendication 5, caractérisé en ce qu'il comprend des moyens d'injection d'eau (74, 76) à l'intérieur d'une colonne (70) reliée à la deuxième sortie (54) du réacteur d'hydrolyse.

7. Dispositif selon l'une quelconque des revendications 1 à 6, caractérisé en ce qu'il comporte un bac de neutralisation (60) relié à la première sortie (52) du réacteur d'hydrolyse (50).

## Patentansprüche

1. Gasabziehvorrichtung für einen Ofen zum chemischen Infiltrieren oder Niederschlagen aus der Dampfphase in einer industriellen Fertigungsanlage für Verbundstoff-Werkstücke,
**gekennzeichnet durch**:
- eine Trockenpumpe (32), die einen Eingang aufweist, der mit dem Ofen (10) verbunden ist, um im Inneren des Ofens Soll-Niederdruckbedingungen schaffen und Restgase abziehen zu können; und
- einen Atmosphärendruck-Hydrolysereaktor (50), der an einen Ausgang der Trockenpumpe angeschlossen ist und dazu dient, von dem Ofen kommende Restgase aufzunehmen, wobei der Hydrolysereaktor einen ersten Ausgang (52) für Feststoff- Niederschläge oder Säurelösungen, die aus der Hydrolyse des aufgenommenen Gases stammen, und einen zweiten, mit der Atmosphäre verbundenen Ausgang für Gas (54) aufweist.

2. Vorrichtung nach Anspruch 1,
**dadurch gekennzeichnet,**
daß sie zwischen dem Eingang der Trockenpumpe (32) und dem Hydrolysereaktor (50) Gasinjektionsmittel (46, 48) aufweist, um einen Gegenstrom von dem Hydrolysereaktor zu der Pumpe zu verhindern.

3. Vorrichtung nach Anspruch 2,
**dadurch gekennzeichnet,**
daß die Gasinjektionsmittel (46, 48) einerseits mit der Trockenpumpe (32) an deren Eingang verbunden sind, andererseits mit einer Leitung (42), welche die Trockenpumpe mit dem Hydrolysereaktor (50) verbindet.

4. Vorrichtung nach einem der Ansprüche 1 bis 3,
**dadurch gekennzeichnet,**
daß sie eine Wasserzuführeinrichtung (74, 76) aufweist, die eine andauernde Flüssigkeitszirkulation zwischen zumindest einem Zugang des Hydrolysereaktors (50) und dessen erstem Ausgang (52) gestattet.

5. Vorrichtung nach Anspruch 4,
**dadurch gekennzeichnet,**
daß die Wasserzuführeinrichtung (74, 76) mit dem Hydrolysereaktor (50) zumindest über dessen zweiten Ausgag (54) verbunden ist, damit aus dem Hydrolysereaktor austretende Säuredämpfe in Lösung gebracht werden und ihr Austritt in die Atmosphäre verhindert wird.

6. Vorrichtung nach Anspruch 5,
**dadurch gekennzeichnet,**
daß sie eine Wassereinspritzeinrichtung (74, 76) aufweist zum Einspritzen von Wasser in das Innere einer Kolonne (70), die an den zweiten Ausgang (54) des Hydrolysereaktors angeschlossen ist.

7. Vorrichtung nach einem der Ansprüche 1 bis 6,
**dadurch gekennzeichnet,**
daß sie einen Neutralisationsbehälter (60) aufweist, der an den ersten Ausgang (52) des Hydrolysereaktors (50) angeschlossen ist.

## Claims

1. A device for extracting gas from an oven for chemical vapor deposition or infiltration in an industrial installation for fabricating parts made of composite material, the device being characterized in that it comprises:
a dry pump (32) having an inlet connected to the oven (10) to enable the desired low pressure conditions to be established inside the oven and to enable residual gases to be extracted therefrom; and
a hydrolysis reactor (50) connected to an outlet of the dry pump and designed to receive the residual gases coming from the oven, the hydrolysis reactor having a first outlet (52) for solid deposits or acid solutions coming from hydrolysis of the gases it receives, and a second outlet (54) for gas that is connected to the atmosphere.

2. A device according to claim 1, characterized in that it includes gas injection means (46, 48) between the inlet to the dry pump (32) and the hydrolysis reactor (50) in order to avoid any backflow from the hydrolysis reactor towards the pump.

3. A device according to claim 2, characterized in that the gas injection means (46, 48) are connected firstly to the dry pump (32) via the inlet thereof, and secondly to a duct (42) connecting the dry pump to the hydrolysis reactor (50).

4. A device according to any one of claims 1 to 3, characterized in that it includes water feed means (74, 76) enabling continuous liquid circulation to be provided at least between one access to the hydrolysis reactor (50) and the first outlet (52) thereof.

5. A device according to claim 4, characterized in that the water feed means (74, 76) are connected to the hydrolysis reactor (50) at least via the second outlet (54) thereof in order to put into solution the acid vapors coming from the hydrolysis reactor and to avoid discharging them into the atmosphere.

6. A device according to claim 5, characterized in that it includes water injection means (74, 76) inside a column (70) connected to the second outlet (54) of the hydrolysis reactor.

7. A device according to any one of claims 1 to 6, characterized in that it includes a neutralizing tank (60) connected to the first outlet (52) of the hydrolysis reactor (50).
